# EUROPEAN PATENT SPECIFICATION

(11) **EP 2 600 627 B1**
(45) Date of publication and mention of the grant of the patent: **03.10.2018**
(21) Application number: 12179991.0
(22) Date of filing: 10.08.2012
(51) Int. Cl.: G09G 3/3233, G09G 3/3291, G09G 3/00

(54) **Detecting method of defects of line and demultiplexer, defect detecting device, and display panel including the defect detecting device**
Erkennungsverfahren für Leitungsfehler und Demultiplexer, Fehlererkennungsvorrichtung und Anzeigetafel mit der Fehlererkennungsvorrichtung
Procédé de détection de défauts de ligne et de démultiplexeur, dispositif de détection de défauts et panneau d'affichage comprenant le dispositif de détection de défauts

(30) Priority: 01.12.2011 KR 20110127807
(43) Date of publication of application: 05.06.2013
(73) Proprietor: Samsung Display Co., Ltd., Gyeonggi-do (KR)
(72) Inventor: Ka, Ji-Hyun, 446-711 Yongin-City (KR); Jeong, Jin-Tae, 446-711 Yongin-City (KR)
(74) Representative: Gulde & Partner

(56) References cited:
- US-A1- 2003 085 855
- US-A1- 2004 012 552
- US-A1- 2008 054 798
- US-A1- 2011 043 500
- US-A1- 2011 221 733

## Description

### BACKGROUND

### 1. Field

One or more embodiments relate to a method and a device for detecting a defect in a demultiplexer and/or a line included in a display device, and a display panel including a defect detecting device.

### 2. Description of the Related Art

Red, Green, and Blue (RGB)-DC voltages and a gate signal are used to check a display panel of an active matrix display device.

In such a display panel, a plurality of red pixels are supplied with a red (R) DC voltage in synchronization with a gate signal, a plurality of green pixels are supplied with a green (G) DC voltage in synchronization with the gate signal, and a plurality of blue pixels are supplied with a blue (B) DC voltage in synchronization with the gate signal.

The red, green, and blue pixels emit light by the R DC voltage, the G DC voltage, and the B DC voltage, and mura, which are black/white spots, line defects, etc., are checked in a light emitting state.

During this checking operation, a demultiplexer positioned between the display panel and the data driving circuit is in an off state. Accordingly, defects of a line between the demultiplexer and the data driving circuit, and a thin film transistor (TFT) forming the demultiplexer, may not be detected.

Prior art helpful for understanding the current invention is disclosed in US 2011/221733 A1, US 2004/012552 A1, US 2011/043500 A1, US 2008/054798 A1 and US 2003/085855 A1.

The above information disclosed in this Background section is only for enhancement of understanding of the background of the invention and therefore it may contain information that does not form the prior art that is already known in this country to a person of ordinary skill in the art.

### SUMMARY

The current invention provides a method according to claim 9, and a display panel according to claim 1.

One or more embodiments provide a defect detecting device using a demultiplexer connecting corresponding ones of a plurality of data lines to a plurality of lines, the defect detecting device including first to third DC lines supplied with first to third DC voltages, a plurality of first switches connected to the first to third DC lines and configured to transmit one of the first to third DC voltages to a plurality of the first data lines among the plurality of data lines according to a first gate signal, and a plurality of second switches connected to the first to third DC lines and configured to transmit one of the first to third DC voltages to a plurality of second data lines among the plurality of data lines according to a second gate signal.

The demultiplexer includes a plurality of first TFTs connecting a plurality of first lines of the plurality of lines and corresponding ones of the plurality of data lines, and a plurality of second TFTs connecting a plurality of second lines of the plurality of lines and corresponding ones of the plurality of data lines, wherein, when the defect detecting device drives the first to third DC lines to a voltage corresponding to an intermediate grayscale among a grayscale range, detects a short defect in the plurality of lines causing the pixel array connected to the shorted line to emit light with a high luminance different from the intermediate grayscale or not to emit light at all, the plurality of the first switches and the plurality of the second switches are in an on state, simultaneously, and only one of the plurality of first TFTs or the plurality of second TFTs are in an on state.

When the plurality of first TFTs are in the on state, corresponding ones of the plurality of lines and the plurality of data lines are connected through the plurality of first TFTs, respectively, and, when one of the plurality of lines is shorted, the plurality of pixels, which are connected to the shorted line via corresponding ones of the data lines, emit light according to a short voltage resulting from the shorted line.

When the plurality of second TFTs are in the on state, simultaneously, corresponding ones of the plurality of lines and the plurality of data lines are connected through the plurality of second TFTs, and when one of the plurality of lines is shorted, the plurality of pixels, which are connected to the shorted line via the corresponding ones of the data lines, emit light according to a short voltage resulting from the shorted line.

The demultiplexer includes a plurality of first TFTs connecting the plurality of lines and corresponding ones of the data lines among the plurality of data lines, a plurality of second TFTs connecting the plurality of lines and corresponding ones of the data lines among the plurality of data lines, and, when the defect detecting device drives the first to third DC lines to a voltage by which no light is emitted from the respective pixels when the demultiplexer works, detects a defect in the plurality of the first TFTs and the plurality of the second TFTs causing a voltage on a respective one of the data lines close to a emitting voltage at which the respective pixel emits light, the plurality of the first TFTs and the plurality of the second TFTs are in an on state, simultaneously, and only one of the plurality of the first switches or the plurality of second switches are in an on state.

When the plurality of the first switches are in the on state, simultaneously, and the plurality of the first TFTs and the plurality of second TFTs are in an on state, the first data lines, which are respectively connected to the plurality of the first switches in the on state are connected to corresponding ones of the second data lines through respective ones of the first and/or the second TFTs.

When at least one of the first and the second TFTs is defective, corresponding ones of the second data lines do not receive and/or transmit the corresponding one of the DC voltages among the first to third DC voltages.

When a plurality of the second switches are in the on state, simultaneously, and the plurality of the first TFTs and the plurality of second TFTs are in an on state, the second data lines, which are respectively connected to the plurality of the second switches in the on state are connected to corresponding ones of the first data lines through respective ones of the first and/or the second TFTs.

When at least one of the first and the second TFTs is defective, corresponding ones of the first data lines do not receive and/or transmit the corresponding one of the DC voltages among the first to third DC voltages.

Each of the plurality of first switches may include a gate electrode configured to receive the first gate signal, a first electrode connected to a corresponding one of the first to third DC lines, and a second electrode connected to a corresponding one of the first data lines.

Each of the plurality of second switches may include a gate electrode configured to receive the second gate signal, a first electrode connected to a corresponding one of the first to third DC lines, and a second electrode connected to a corresponding one of the second data lines.

One or more embodiment provide a defect detecting method for a line connected to a first data line corresponding to a first pixel array and a second data line corresponding to a second pixel array through a first TFT and a second TFT, the defect detecting method including supplying a first DC voltage to the first data line and the second data line, turning on only one of the first TFT and the second TFT, and detecting a defect according to a light emitting state of the first or the second pixel array connected to the turned-on one of the first and the second TFTs.

When the first TFT is turned on, detecting a defect may include detecting the line as defective when the first pixel array is in a light emitting state that produces a dark line or a bright line relative to a predetermined luminance.

Detecting a defect may include detecting the line as defective when the first pixel array is in a light emitting state that produces a line that is dark or bright relative to an intermediate grayscale among a grayscale range.

When the second TFT is turned on, detecting a defect may include detecting the line as defective when the second pixel array is in a light emitting state that produces a dark line or a bright line relative to a predetermined luminance.

One or more embodiments provide a defect detecting method for a demultiplexer including a first TFT and a second TFT respectively connected to a first data line connected to a first switch and a first pixel array, and a second data line connected to a second switch and a second pixel array, the defect detecting method including turning on only one of the first switch and the second switch, turning on the first TFT and the second TFT, and detecting a defect in the first TFT and/or the second TFT according to a light emitting state of the first pixel array and the second pixel array.

Detecting a defect may include detecting a defect in the first TFT and/or the second TFT when the light emitting state of the first pixel array and the second pixel array are different.

When the first switch is turned on, detecting a defect may include detecting at least one of the first TFT and the second TFT as defective when the first pixel array is displayed with black and the second pixel array is displayed with a predetermined luminance.

When the second switch is turned on, detecting a defect may include detecting at least one of the first TFT and the second TFT as defective when the second pixel array is displayed with black, and the first pixel array is displayed with a predetermined luminance.

One or more embodiments provide a display panel including a plurality of data lines, a plurality of pixels respectively connected to the plurality of data lines, a demultiplexer connecting a plurality of data lines to a plurality of corresponding lines, and a defect detecting device configured to detect a defect in a plurality of lines and/or the demultiplexer, the defect detecting device including a plurality of first switches configured to transmit one among first to third DC voltages to a plurality of corresponding first data lines among a plurality of data lines according to a first gate signal, and a plurality of second switches configured to transmit one among the first to third DC voltages to a plurality of corresponding second data lines among a plurality of data lines according to a second gate signal.

### BRIEF DESCRIPTION OF THE DRAWINGS

Features will become apparent to those of ordinary skill in the art by describing in detail exemplary embodiments with reference to the attached drawings, in which:
FIG. 1 illustrates a schematic diagram of a display device including a defect detecting device according to an exemplary embodiment;
FIG. 2 illustrates a schematic diagram of an exemplary embodiment of a pixel of the display device of FIG. 1;
FIG. 3 illustrates a schematic view of the defect detecting device and the demultiplexer of FIG. 1 in a defective state;
FIG. 4 illustrates a schematic view of the defect detecting device and the demultiplexer of FIG. 1 in another defective state;
FIG. 5 illustrates a schematic view of the defect detecting device and the demultiplexer of FIG. 1 in another defective state;
FIG. 6 illustrates a schematic view of the defect detecting device and the demultiplexer of FIG. 1 in another defective state;
FIG. 7 illustrates a schematic view of the defect detecting device and the demultiplexer of FIG. 1 in another configuration for detecting a defective state of the demultiplexer;
FIG. 8 illustrates a schematic view of the defect detecting device and the demultiplexer of FIG. 1 according to the configuration of Fig. 7 , wherein the demultiplexer is in a defective state;
FIG. 9 illustrates a schematic view of the defect detecting device and the demultiplexer of FIG. 1 in yet another configuration for detecting a defective state of the demultiplexer; and
FIG. 10 illustrates a schematic view of the defect detecting device and the demultiplexer of FIG. 1 according to the configuration of Fig. 9 , wherein the demultiplexer is in another defective state.

### DETAILED DESCRIPTION

In the following detailed description, only certain exemplary embodiments of the present invention have been shown and described, simply by way of illustration. As those skilled in the art would realize, the described embodiments may be modified in various different ways, all without departing from the scope of the present invention. Accordingly, the drawings and description are to be regarded as illustrative in nature and not restrictive. Like reference numerals designate like elements throughout the specification.

Throughout this specification and the claims that follow, when it is described that an element is "coupled" to another element, the element may be "directly coupled" to the other element or "electrically coupled" to the other element through a third element. In addition, unless explicitly described to the contrary, the word "comprise" and variations such as "comprises" or "comprising" will be understood to imply the inclusion of stated elements but not the exclusion of any other elements.

Exemplary embodiments of a defect detecting method, a defect detecting device, and a display device including the same will be described with reference to accompanying drawings.

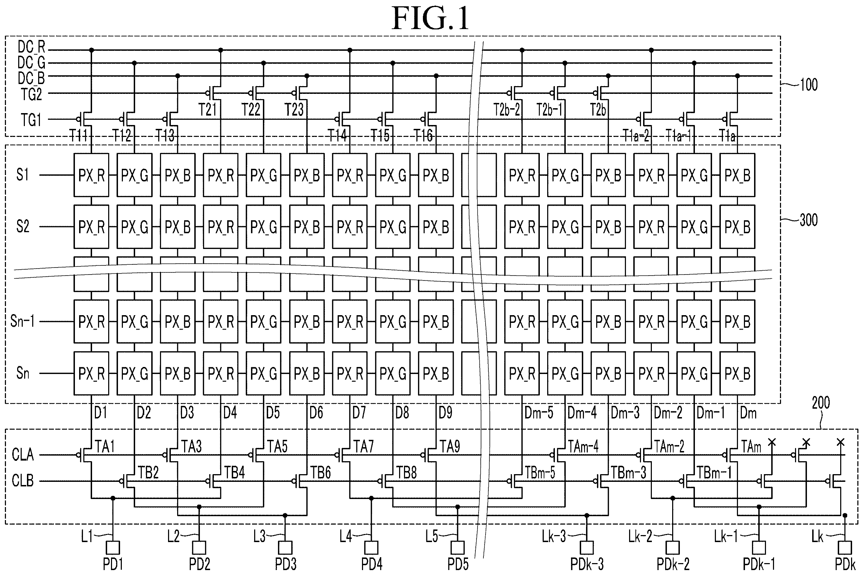

FIG. 1 illustrates a schematic diagram of an exemplary embodiment of a display device including a defect detecting device 100, a demultiplexer 200, and/or a display unit 300.

The display unit 300 may include a plurality of scan lines S1-Sn, a plurality of data lines D1-Dm, and a plurality of pixels PX_R, PX_G, PX_B formed at intersection regions of the scan lines Sl-Sn and the data lines D1-Dm.

The defect detecting device 100 may be connected to the plurality of data lines D1-Dm and may transmit a red DC voltage RDV, a green DC voltage GDV, and a blue DC voltage BDV to the plurality of data lines D1-Dm according to a plurality of, e.g., two, test gate signals TGS1, TGS2.

The defect detecting device 100 may include a plurality of, e.g., two, gate lines TG1, TG2, a red DC line DC_R, a green DC line DC_G, a blue DC line DC_B, a plurality of the first control switches T11-T1a, and a plurality of the second control switches T21-T2b.

Referring to FIG. 1, the first gate line TG1 may be connected to gate electrodes of the plurality of first control switches T11-T1a, and the second gate line TG2 may be connected to gate electrodes of a plurality of the second control switches T21-T2b.

The first gate signal TGS1 may be transmitted to the gate electrodes of the plurality of first control switches T11-T1a through the first gate line TG1. The second gate signal TGS2 may be transmitted to the gate electrodes of the plurality of second control switches T21-T2b through the second gate line TG2.

The plurality of the first control switches T11-T1a and the plurality of the second control switches T21-T2b may be realized by P channel transistors. In such embodiments, an enable level of the first and second gate signals TGS1 and TGS2 is a low level while a disable level is a high level.

The plurality of the first switches T11-T1a may each include a source electrode connected to a corresponding one of DC lines among the red DC line DC_R, the green DC line DC_G, and the blue DC line DC_B, and a drain electrode connected to the corresponding data line among the plurality of data lines D1-Dm.

The plurality of the second switches T21-T2b may each include a source electrode connected to a corresponding one of the DC lines among the red DC line DC_R, the green DC line DC_G, and the blue DC line DC_B, and a drain electrode connected to the corresponding data line among the plurality of data lines D1-Dm.

In the display unit 300, the plurality of scan lines S1-Sn may be arranged to extend in a row direction, and a plurality of pixels PX_R, PX_G, and PX_B of one row may be connected to the same scan line. The plurality of data lines D1-Dm may be arranged to extend in a column direction, and the plurality of pixels PX_R, PX_G, and PX_B of one column may be connected to the same data line.

Each of the plurality of pixels PX_R, PX_G, PX_B may include a driving circuit and a light emitting element. Each driving circuit of the plurality of pixels PX_R, PX_G, PX_B may write the data signal transmitted through the corresponding data line by the scan signal transmitted through the corresponding scan line, and a driving current according to the written data signal may be generated and supplied to the respective light emitting element.

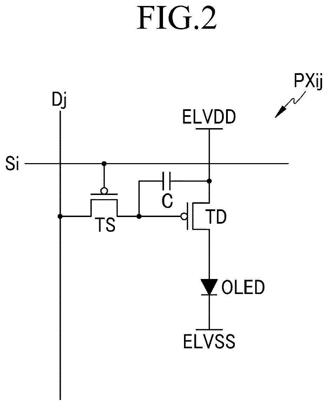

FIG. 2 illustrates a schematic diagram of an exemplary embodiment of a pixel PXij of the display device of FIG. 1. The pixel PXij may correspond to one, some or all of the plurality of pixels PX_R, PX_G, PX_B of the display unit 300. The pixel PXij shown in FIG. 2 is a pixel connected to the i-th scan line Si and the j-th data lines Dj. Exemplary embodiments are not limited thereto.

As shown in FIG. 2, the pixel PXij may include a switching transistor TS, a driving transistor TD, a capacitor C, and an organic light emitting device (OLED).

The switching transistor TS may include a gate electrode connected to the scan line Si, a first electrode connected to the data line Dj, and a second electrode connected to the gate electrode of the driving transistor TD.

The driving transistor TD may include a source electrode connected to a first voltage source ELVDD, a drain electrode connected to an anode of the organic light emitting device (OLED), and a gate electrode connected to the switching transistor TS.

The capacitor C may be connected between the gate electrode and the source electrode of the driving transistor TD, and a cathode of the OLED is connected to a second voltage source ELVSS.

When a scan signal transmitted through the scan line Si is the low level, the switching transistor TS is turned on, and the capacitor C is charged by the data signal transmitted through the data lines Dj.

The gate voltage of the driving transistor TD is constantly maintained by the capacitor C for a next scan, and a driving current of the driving transistor TD is generated depending on a difference of the gate-source voltage thereof. The organic light emitting device (OLED) may emit light according to the driving current.

The demultiplexer 200 may be connected between a plurality of lines L1-Lk and a plurality of data lines D1-Dm. The plurality of lines L1-Lk are connected to a plurality of pads PD1-PDk, and a plurality of data signals input to a plurality of pads PD1-PDk are transmitted to the demultiplexer 200 through a plurality of lines L1-Lk.

The demultiplexer 200 may transmit a plurality of data signals transmitted through a plurality of lines L1-Lk to a plurality of corresponding data lines through a plurality of thin fil transistors (TFTs). The demultiplexer 200 may include a plurality of first TFTs TA1, TA3, ..., TAm, a plurality of second TFTs TB2, TB4, ..., TBm-1, a first control line CLA, and a second control line CLB.

The first control line CLA is connected to gate electrodes of the plurality of first TFTs TA1, TA3, ..., TAm. A first control signal CON1 for controlling the plurality of first TFTs TA1, TA3, ..., TAm through the first control line CLA is transmitted to the gate electrodes of the plurality of first TFTs TA1, TA3, ..., TAm.

The second control line CLB is connected to gate electrodes of the plurality of second TFTs TB2, TB4, ..., TBm-1. A second control signal CON2 for controlling a plurality of the second TFTs TB2, TB4, ..., TBm-1 through the second control line CLB is transmitted to the gate electrodes of the plurality of second TFTs TB2, TB4, ..., TBm-1.

In one or more embodiments in which a plurality of pads PD1-PDk are connected to a data driving circuit (not shown), a plurality of data signals may be input from the data driving circuit to the plurality of pads PD1-PDk.

In one or more embodiments, if the plurality of first TFTs TA1, TA3, ..., TAm are turned on by the first control signal CON1, the plurality of data lines D1, D3, ..., Dm may transmit respective data signals, and if the plurality of second TFTs TB2, TB4, ..., TBm-1 are turned on by the second control signal CON2, the plurality of data lines D2, D4, ..., Dm-1 may transmit respective data signals.

In one or more embodiments, it may be determined that there is a defect in one or more of the lines L1-Lk and/or a defect in the demultiplexer 200 if the plurality of the first TFTs TA1, TA3, ..., TAm and the plurality of the second TFTs TB2, TB4, ..., TBm-1, and a plurality of pads PDl-PDk are not connected to the data driving circuit.

When detecting a defect in the plurality of lines Ll-Lk, only one group of a plurality of the first TFTs TA1, TA3, ..., TAm and the plurality of the second TFTs TB2, TB4, ..., TBm-1 may be in a turn-on state. When detecting a defect in the plurality of the first TFTs TA1, TA3, ..., TAm and a plurality of the second TFTs TB2, TB4, ..., TBm-1, may be in a turn-on state.

In one or more embodiments, when a defect in lines L1-Lk is determined through the defect detecting device 100, the first and second gate signals TGS1 and TGS2 are both at the enable level. In one or more embodiments, when a defect in the demultiplexer 200 is determined through the defect detecting device 100, only one of the first and second gate signals TGS1 and TGS2 is at the enable level.

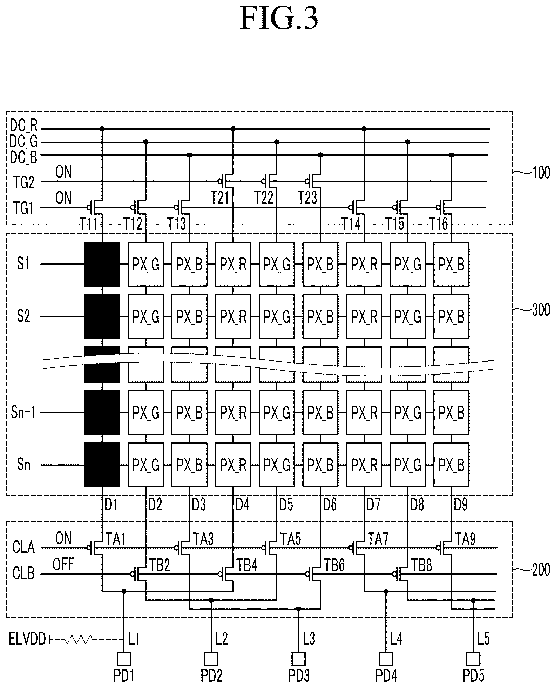

Next, an exemplary embodiment of a method of detecting a line defect will be described with reference to FIG. 3 to FIG. 6. For better understanding and ease of description, in FIGS. 3-6, nine (9) pixels in each row are shown as an example of a plurality of pixels.

To detect a line defect, the plurality of scan lines Sl-Sn transmit a plurality of scan signals having a level for turning on the respective switching transistor TS. When detecting a line defect, a level of the red, green, and blue DC voltages RDV, GDV, and BDV is determined according to a detecting condition.

For example, if a line is short-circuited to the second voltage source ELVSS, the pixel array connected to the shorted line emits light with a high luminance. Alternatively, if the line is short-circuited to the first voltage source ELVDD, the pixel array connected to the shorted line does not emit light. Accordingly, a degree of the red, green, and/or blue DC voltage RDV, GDV, and BDV levels may be used to distinguish a pixel array connected to a normal line from a pixel array connected to a line shorted to the first voltage source ELVSS or the second voltage source ELVDD.

In one or more embodiments, the red, green, and blue DC voltages RDV, GDV, and BDV may be determined as a same level as a data voltage corresponding to an intermediate grayscale among a grayscale range.

FIG. 3 illustrates a schematic view of the defect detecting device 100 and the demultiplexer 200 of FIG. 1 in a defective state (e.g., line L1 shorted with the first voltage source ELVDD).

As shown in FIG. 3, the plurality of first switches T11-T1a and the plurality of tsecond switches T21-T2b are all in a turned-on state by the first gate signal TGS1 and the second gate signal TGS2, and the plurality of first TFTs TA1, TA3, ..., TAm are in a turn-on state by the first control signal CON1. Thus, a plurality of lines L1-Lk are connected to a plurality of data lines D1-Dm through a plurality of the turned-on first TFTs TA1, TA3, ..., TAm.

In the exemplary embodiment of FIG. 3, the plurality of data lines D1-Dm are supplied with corresponding DC voltages among the red, green and blue DC voltages RDV, GDV, and BDV through the corresponding first switch (or the second switch), and the plurality of pads PD1-PDk are not connected to the data driving circuit, thereby being in a floating state. Accordingly, the red, green, and blue DC voltages RDV, GDV, and BDV transmitted through a plurality of data lines D1-Dm are transmitted to a plurality of pixels PX_R, PX_G, and PX_B, and the plurality of pixels PX_R, PX_G, and PX_B emit the light according to the red, green, and blue DC voltages RDV, GDV, and BDV.

At this time, if a short line is generated in one or more among the plurality of lines Ll-Lk, the data lines connected to the short line are shorted through the short line, and respective ones of the plurality of pixels PX_R, PX_G, and PX_B connected to the shorted data lines emit light with a luminance different from that of the pixels connected to the line that is not shorted.

For example, as shown in FIG. 3, it is assumed that the line L1 is shorted to the first voltage source ELVDD. A resistor component may exist between the line L1 and the first voltage source ELVDD.

The line L1 is connected to the data line D1 through the turned-on first TFT TA1. Accordingly, the data line D1 is supplied with a high level voltage similar to a voltage of the first voltage source ELVDD. Thus, a gate electrode of the driving transistor TD is supplied with the high level voltage through the switching transistor TS shown in FIG. 2.

Accordingly, a plurality of pixels PX_R connected to the data line D1 emit light with very low luminance. That is, a dark line appears according to the data line D1. As described above, the line electrically connected to the data line D1 connected to the pixel column may be detected as a shorted line.

In the exemplary embodiment of FIG. 3, the line L1 is shorted with the first voltage source ELVDD, in one or more embodiments, one or more of the lines L1-Lk may be shorted with other components, e.g., the lines L1-Lk may be shorted to the second voltage source ELVSS.

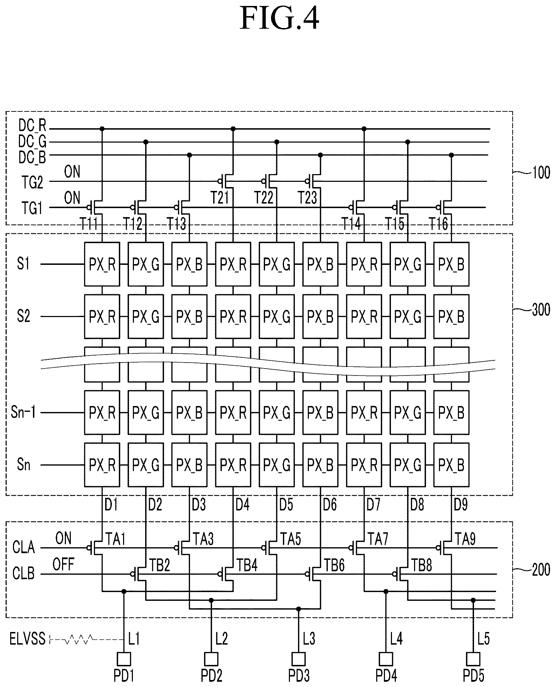

FIG. 4 illustrates a schematic view of the defect detecting device 100 and the demultiplexer 200 of FIG. 1 in another defective state (e.g., L1 shorted with the second power source voltage ELVSS). More particularly, FIG. 4 shows a state that the line L1 is shorted to the voltage ELVSS. Thus, the data line D1 is supplied with a low level voltage similar to a voltage of the second voltage source ELVSS. Accordingly, the gate electrode of the driving transistor TD is supplied with the low level voltage through the respective switching transistor TS.

Accordingly, the plurality of pixels PX_R connected to the data line D1 emit light with very high luminance. That is, a bright line appears according to the data line D1. As described above, as a result of the luminance level, e.g., the line electrically connected to the corresponding data line connected to the pixel column may be detected as shorted.

As described above, in one or more embodiments, a line corresponding to a pixel column displayed as relatively darker line or a relatively brighter line among a plurality of pixel columns may be determined to be shorted. Further, in the exemplary embodiment and conditions of FIG. 3, when the line L2 is shorted with the first voltage source ELVDD, the pixel column connected to the data lines D5 would be displayed as a dark line, when the line L3 is shorted with ELVDD, the pixel column connected to the data lines D3 would be displayed as a dark line, and when the line L4 is shorted with ELVDD, the pixel column connected to the data lines D7 would be displayed as a dark line. Analogously, in the exemplary embodiment of Fig. 4, when one of the lines L2, L3 or L4 is shorted with the second voltage source ELVSS, the pixels connected to the corresponding data lines D5, D3 and D7, respectively, would display a bright line.

In the exemplary embodiments of FIGS. 3 and 4, a condition that a plurality of the first TFTs TA1, TA3, ..., TAm are in the turned-on state is described, however, in one or more embodiments, a plurality of the second TFTs TB2, TB4, ..., TBm-1 instead of a plurality of the first TFTs TA1, TA3, ..., TAm may be in the turned-on state.

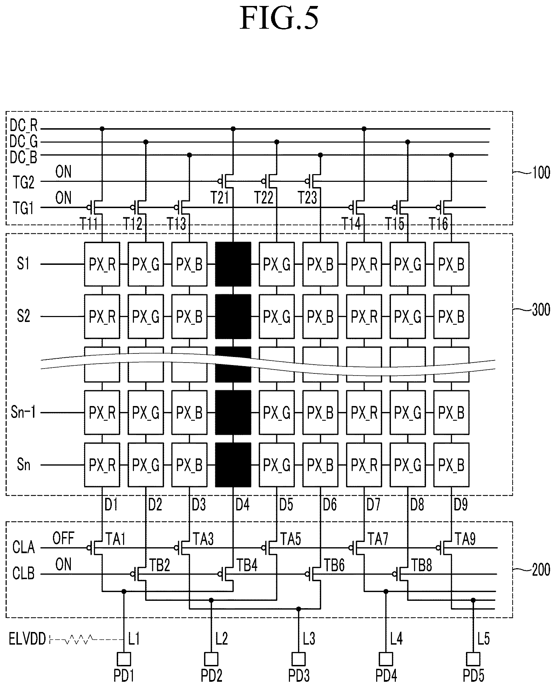

FIG. 5 illustrates a schematic view of the defect detecting device 100 and the demultiplexer 200 of FIG. 1 in another defective state. In general, only differences between the different exemplary defective states are described below. As shown in FIG. 5, when a plurality of the second TFTs TB2, TB4, ..., TBm-1 are in the turn-on state, only operations of the pixel array corresponding to the shorted line (e.g., line L1 shorted with the first voltage source ELVDD) are different form the above description of the pixels in a normal state (e.g., not shorted state). In FIG. 5, it is assumed that the line L1 is shorted to the voltage ELVDD. A resistor component may exist between the line L1 and the voltage ELVDD.

The line L1 is connected to the data line D4 through the turned-on second TFT TB4. Accordingly, the data line D4 is supplied with a high level voltage similar to a voltage of the first voltage source ELVDD. Thus, the gate electrode of the respective driving transistor TD is supplied with the high level voltage through the respective switching transistor TS shown in FIG. 2.

Accordingly, a plurality of the pixels PX_R connected to the data line D4 emit light with very low luminance. That is, the dark line appears according to the data line D4. As described above, the line electrically connected to the data line connected to the pixel column that is displayed as a dark line may be detected to be shorted.

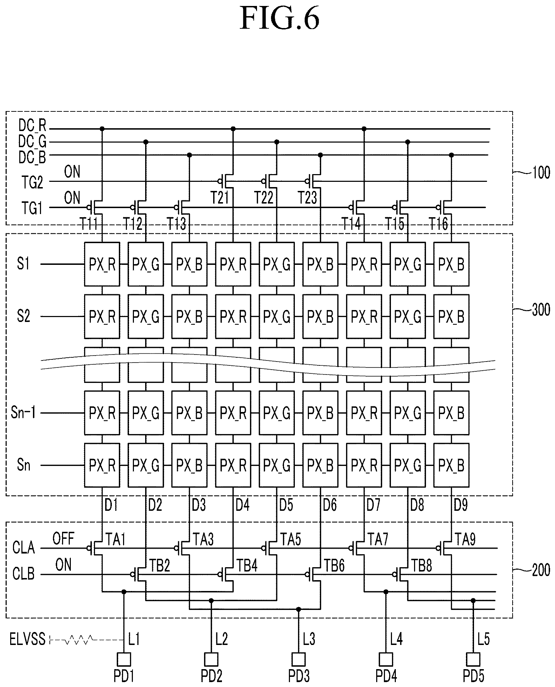

FIG. 6 illustrates a schematic view of the defect detecting device 100 and the demultiplexer 200 of FIG. 1 in another defective state, e.g., a short line is generated. More particularly, FIG. 6 shows a state wherein the line L1 is shorted to the voltage ELVSS. As shown in FIG. 6, a plurality of the first switches T11-T1a and a plurality of the second switches T21-T2b are all in a turned-on state by the first gate signal TGS1 and the second gate signal TGS2, and a plurality of the second TFTs TB1, TB3, ..., Tbm are in a turned-on state by the second control signal CON2.

Thus, the data lines D4 is supplied with the voltage of the low level similar to the voltage ELVSS. Therefore, the voltage of the low level is supplied to the gate electrode of the driving transistor TD through the switching transistor TS.

Accordingly, a plurality of pixels PX_R connected to the data line D4 emit light with very high luminance. That is, the bright line appears according to the data lines D4. As described above, the line electrically connected to the data line connected to the pixel column displayed as the bright line may be detected as shorted.

Through this method, the line corresponding to the pixel column that is displayed as the dark line or the bright line among a plurality of pixel columns may be determined as shorted. In the exemplary embodiments and conditions of FIGs. 5 and 6, i.e. the second TFTs are turned on and the first TFTs are turned off, when the line L2 is shorted, the pixel column connected to the data line D2 is displayed as a bright line (i.e., relatively bright line) or a dark line (i.e., relatively dark line), when the line L3 is shorted, the pixel column connected to the data line D6 is displayed as a bright line or a dark line, and when the line L5 is shorted, the pixel column connected to the data line D8 is displayed as the bright line or the dark line.

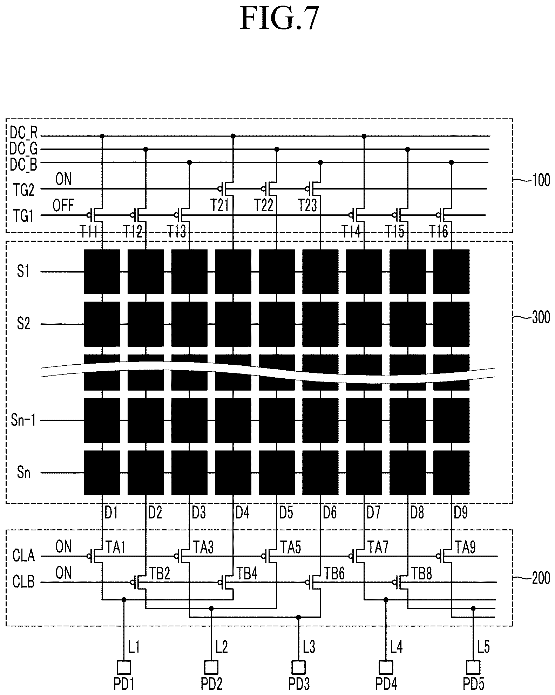

Next, an exemplary embodiment of a defect detecting method of the demultiplexer 200 will be described with reference to FIG. 7 to 10.

Like FIGS. 3-6, FIGS. 7-10 exemplarily show nine (9) pixel columns for understanding and ease of description.

Furthermore, to detect the defect of the demultiplexer, a plurality of scan lines S1-Sn are transmitted with a plurality of scan signals of the level for turning on the switching transistor TS. When detecting the defect of the demultiplexer, the level of the red, green, and blue DC voltages RDV, GDV, and BDV may be determined as the appropriate voltage capable of detecting the defective TFT generated in the demultiplexer.

FIG. 7 illustrates schematic view of the defect detecting device 100 and the demultiplexer 200 of FIG. 1 in another configuration for detecting a defective state within the demultiplexer 200, e.g., a defective TFT is generated in the demultiplexer 200.

As shown in FIG. 7, only the switch of one group is in the turn-on state among the plurality of first switches T11-T1a and the plurality of second switches T21-T2b by the first gate signal TGS1 and the second gate signal TGS2.

In an exemplary embodiment of FIG. 7, the plurality of second switches T21-T2b are turned on by the second gate signal TG2 and the plurality of first switches T11 - T1a are turned off by the first gate signal TG1.

Furthermore,thea plurality of first TFTs TA1, TA3, ..., TAm are in the turn-on state by the first control signal CON1, and the plurality of second TFT TB2, TB4, ..., TBm-1 are in the turn-on state by the second control signal CON2.

Thus, the red, green, and blue DC voltages RDV, GDV, and BDV are connected to the plurality of data lines D1-Dm through the plurality of second switches T21-T2b, the plurality of first TFTs TA1, TA3, ..., TAm, and the plurality of second TFTs TB2, TB4, ..., TBm-1 that are turned on.

That is, all red, green, and blue pixels PX_R, PX_G, and PX_B of the display unit 300 are supplied with the corresponding red, green, and blue DC voltages RDV, GDV, and BDV.

In the exemplary embodiment of Fig. 7, the red, green, and blue DC voltages RDV, GDV, and BDV for the detection of the defect of the demultiplexer 300 may be determined as a voltage corresponding to a voltage by which no light is emitted from the respective pixels when the demultiplexer works correctly.

In detail, a path including the second switch T21, the data line D4, the second TFT TB4, the first TFT TA1, and the data line D1 is formed, and the red DC voltage RDV is supplied to a plurality of red pixels PX_R connected to the data line D1 and the data line D4. A path including the second switch T22, the data line D5, the first TFT TA5, the second TFT TB2, and the data line D2 is formed, and the green DC voltage GDV is supplied to a plurality of green pixels PX_G connected to the data line D2 and the data line D5. A path including the second switch T23, the data line D6, the second TFT TB6, the first TFT TA3, and the data line D3 is formed, and the blue DC voltage BDV is supplied to a plurality of blue pixels PX_B connected to the data line D3 and the data line D6.

Through this method, if all pixels are supplied with the corresponding DC voltage, the entire display unit 300 displays the black. However, when a defective TFT is generated in one or more among the first TFTs TA1, TA3, ..., TAm and the second TFTs TB2, TB4, ..., TBm-1 forming the demultiplexer 200, the data line of the path including the defective TFT is not supplied with the corresponding DC voltage.

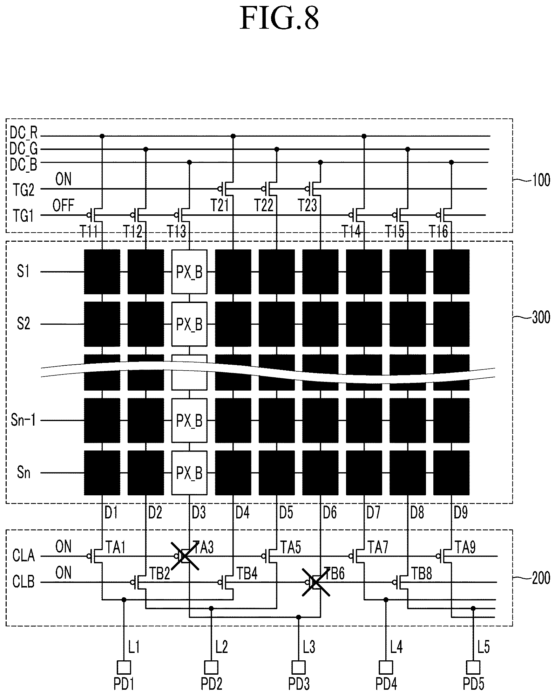

FIG. 8 illustrates a schematic view of the defect detecting device 100 and the demultiplexer 200 of FIG. 1 according to the detecting configuration of Fig. 7 wherein a defective TFT is generated in the demultiplexer 200. For example, it is assumed that at least one among the second TFT TB6 and the first TFT TA3 is defective.

When the second TFT TB6 is defective, the data lines D3 are not supplied with the blue DC voltage BDV. Accordingly, a plurality of pixels PX_B connected to the data line D3 do not display the black and emit light with a predetermined luminance. That is, the bright line is generated. When the first TFT TA3 instead of the second TFT TB6 is defective, the pixel column connected to the data line D3 is displayed with the bright line. That is, at least one of the first TFT and the second TFT connected to the data line is defective.

Through this method, the first TFT TA3 or the second TFT TB6that is defective may be detected by detecting the data line corresponding to the pixels which emit light at a predetermined luminance, i.e. which are brighter than the other pixel lines.

However, embodiments are not limited thereto, and a plurality of the first switches T11-T1 a instead of a plurality of the second switches T21-T2b may be turned on.

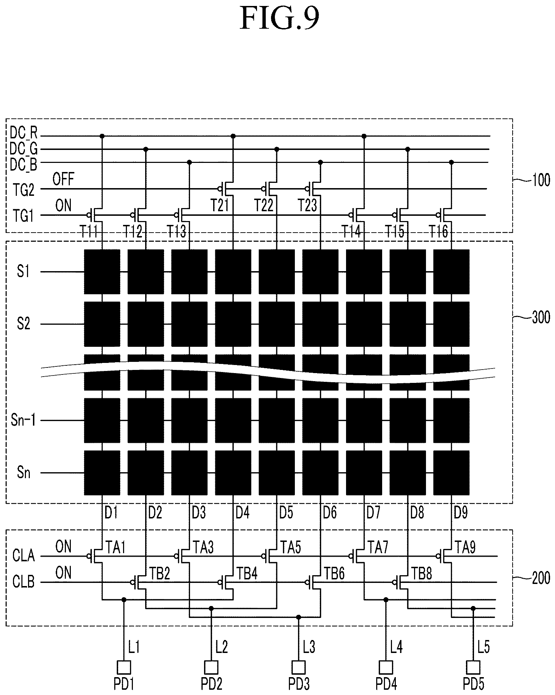

FIG. 9 illustrates a schematic view of the defect detecting device 100 and the demultiplexer 200 of FIG. 1 in another configuration for detecting a defective state within the demultiplexer 200, e.g., a defective TFT is generated in the demultiplexer 200.

As shown in FIG. 9, it is assumed that the plurality of second switches T21-T2b are turned off by the second gate signal TG2, and the plurality of first switches T 11-T1 a are turned on by the first gate signal TG1.

Furthermore, the plurality of first TFTs TA1, TA3, ..., TAm are in the turned-on state by the first control signal CON1, and the plurality of second TFT TB2, TB4, ..., TBm-1 are in the turn-on state by the second control signal CON2.

Thus, the red, green, and blue DC voltages RDV, GDV, and BDV are connected to the plurality of data lines D1-Dm through the first switches T11-T 1a, the first TFTs TA1, TA3, ..., TAm, and the second TFTs TB2, TB4, ..., TBm-1 that are turned on.

That is, all red, green, and blue pixels PX_R, PX_G, and PX_B of the display unit 300 may be supplied with the corresponding red, green, and blue DC voltages RDV, GDV, and BDV, and the red, green, and blue DC voltages RDV, GDV, and BDV to detect the defect of the demultiplexer 300 may be determined as the voltage capable of light-emitting the pixel.

In detail, the path including the first switch T11, the data line D1, the first TFT TA1, the second TFT TB4, and the data line D4 is formed, and the red DC voltage RDV is supplied to a plurality of red pixels PX_R connected to the data line D1 and the data line D4. The path including the first switch T12, the data line D2, the second TFT TB2, the first TFT TA5, and the data line D5 is formed, and the green DC voltage GDV is supplied to a plurality of green pixels PX_G connected to the data line D2 and the data line D5. The path including the first switch T13, the data line D3, the first TFT TA3, the second TFT TB6, and the data line D6 is formed, and the blue DC voltage BDV is supplied to a plurality of blue pixels PX_B connected to the data line D3 and the data line D6.

If all pixels are supplied with the corresponding DC voltage, the entire display unit 300 is displayed as black. However, when a defective TFT is generated among the first TFTs TA1, TA3, ..., TAm and the second TFTs TB2, TB4, ..., TBm-1 forming the demultiplexer 200, the data line including the defective TFT is not supplied with the corresponding DC voltage.

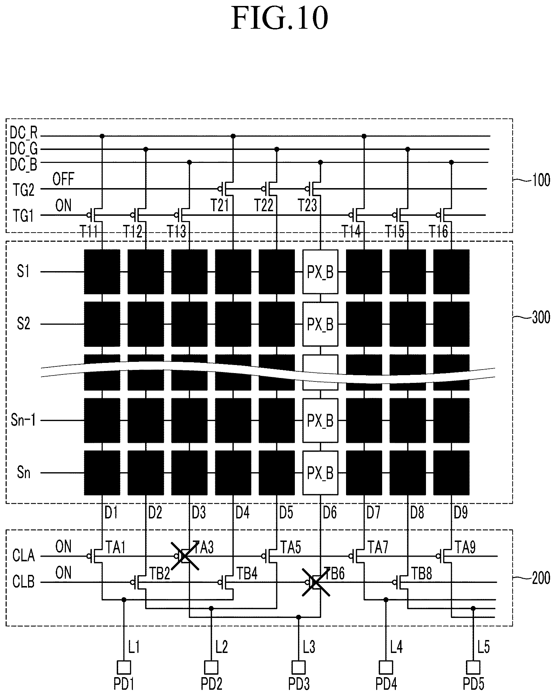

FIG. 10 illustrates a schematic view of the defect detecting device 100 and the demultiplexer 200 of FIG. 1 according to the detecting configuration of Fig. 9 wherein a defective state within the demultiplexer 200 occurs. For example, it is assumed that at least one of the second TFT TB6 and the first TFT TA3 is defective like in FIG. 8.

When the second TFT TB6 is defective, the data line D6 is not supplied with the blue DC voltage BDV. Accordingly, a plurality of pixels PX_B connected to the data line D6 are not displayed with the black, but are light-emitted with the predetermined luminance. That is, the bright line is generated. When the first TFT TA3 is defective instead of the second TFT TB6, the pixel column connected to the data line D6 is also displayed with the bright line. That is, at least one of the first TFT and the second TFT connected to the data line is defective.

Through this method, if the first TFT TA3 or the second TFT TB6 is defective, this may be detected by detecting the bright line that is generated.

Example embodiments have been disclosed herein, and although specific terms are employed, they are used and are to be interpreted in a generic and descriptive sense only and not for purpose of limitation. Accordingly, it will be understood by those of skill in the art that various changes in form and details may be made without departing from the scope of the present invention as set forth in the following claims.

### Description of Symbols

defect detecting device 100
data lines D1-Dm
test gate signals TGS1 and TGS2
red DC voltage RDV
green DC voltage GDV
blue DC voltage BDV
gate line TG1 and TG2
red DC line DC_R
green DC line DC_G
blue DC line DC_B
first control switch T11-T1a
display unit 300
second control switch T21-T2b
scan line S1-Sn
pixel PX_R, PX_G, PX_B
switching transistor TS
driving transistor TD
capacitor C
organic light emitting element OLED
first TFT TA1, TA3, ... TAm
second TFT TB2, TB4, ... TBm-1
first control line CLA
second control line CLB
line L1-Lk
pad PD1-PDk

## Claims

1. A display panel, comprising:
a plurality of data lines (D1, D2, ..., Dm);
a plurality of pixels (PX_R, PX_G, PX_B) respectively connected to the plurality of data lines (D1, D2, ..., Dm);
a demultiplexer (200) connecting a plurality of data lines (D1, D2, ..., Dm) to a plurality of corresponding lines (L1, L2,..., Lk); and
a defect detecting device (100) configured to detect a defect in a plurality of lines (L1, L2,..., Lk) and/or the demultiplexer (200),
wherein the defect detecting device (100) comprises:
first to third DC lines (DC_R, DC_G, DC_B) supplied with first to third DC voltages;
a plurality of first switches (T11, T12, ..., T1a) connected to the first to third DC lines (DC_R, DC_G, DC_B) and configured to transmit one of the first to third DC voltages to a plurality of the first data lines (D1, D2, D3, D7, D8, D9) among the plurality of data lines (D1, D2, ..., Dm) according to a first gate signal; and
a plurality of second switches (T21, T22,..., T2b) connected to the first to third DC lines (DC_R, DC_G, DC_B) and configured to transmit one of the first to third DC voltages to a plurality of second data lines (D4, D5, D6, Dm-5, Dm-4, Dm-3) among the plurality of data lines (D1, D2, ..., Dm) according to a second gate signal,wherein the demultiplexer (200) includes:
a plurality of first TFTs (TA1, TA3,..., TAm) connected between the plurality of lines (L1, L2,..., Lk) and corresponding ones of a plurality of data lines (D1, D3, ...Dm), and
a plurality of second TFTs (TB2, TB4,..., TBm-1) connected between the plurality of lines (L1, L2,..., Lk) and corresponding ones of another plurality of data lines (D2, D4,....Dm-1), and
**characterized in that**
the defect detecting device (100) is configured to drive the first to third DC lines (DC_R, DC_G, DC_B) to a gray-emitting voltage where the pixels (PX_R, PX_G, PX_B) do emit an intermediate grayscale, and to reveal a short defect among the plurality of lines (L1, L2,..., Lk) by causing the pixel array connected to the shorted line to emit light with a high luminance different from the intermediate grayscale or not to emit light at all, in a state when the plurality of the first switches (T11, T12, ..., T1a) and the plurality of the second switches (T21, T22,..., T2b) of the defect detecting device (100) are in an on state, simultaneously, and, only one of the plurality of first TFTs (TA1, TA3,..., TAm) and the plurality of second TFTs (TB2, TB4,..., TBm-1) of the demultiplexer (200), are in an on state, and
the defect detecting device (100) is further configured drive the first to third DC lines (DC_R, DC_G, DC_B) to a non-emitting voltage where the pixels (PX_R, PX_G, PX_B) do not emit light, and to reveal a defect in the plurality of first TFTs (TA1, TA3,..., TAm) and the plurality of second TFTs (TB2, TB4,..., TBm-1) by causing the voltage on the corresponding one of the data lines to be at a level at which the respective pixels emit light, in a state when the plurality of first TFTs (TA1, TA3,..., TAm) and the plurality of second TFTs (TB2, TB4,..., TBm-1) are in an on state, simultaneously, and, only one of the plurality of first switches (T11, T12, ..., T1a) and the plurality of second switches (T21, T22,..., T2b), are in an on state.

2. The display panel as claimed in claim 1, wherein each of the plurality of first switches (T11, T12, ..., T1a) includes a gate electrode configured to receive the first gate signal, a first electrode connected to a corresponding one of the first to third DC lines (DC_R, DC_G, DC_B), and a second electrode connected to a corresponding one of the first data lines (D1, D2, D3, D7, D8, D9).

3. The display panel as claimed in one of the preceding claims, wherein each of the plurality of second switches (T21, T22,..., T2b) includes a gate electrode configured to receive the second gate signal, a first electrode connected to a corresponding one of the first to third DC lines (DC_R, DC_G, DC_B), and a second electrode connected to a corresponding one of the second data lines (D4, D5, D6, Dm-5, Dm-4, Dm-3).

4. The display panel as claimed in one of the preceding claims, wherein:
when the plurality of first TFTs (TA1, TA3,..., TAm) are in the on state, corresponding ones of the plurality of lines (L1, L2,..., Lk) and the plurality of data lines (D1, D2, ..., Dm) are connected through the plurality of first TFTs (TA1, TA3,..., TAm), respectively, and
when one of the plurality of lines (L1, L2,..., Lk) is shorted, the plurality of pixels (PX_R, PX_G, PX_B), which are connected to the shorted line via corresponding ones of the data lines (D1, D2, ..., Dm), is adapted to emit light according to a short voltage resulting from the shorted line.

5. The display panel as claimed in one of the preceding claims, wherein:
when the plurality of second TFTs (TB2, TB4,..., TBm-1) are in the on state, corresponding ones of the plurality of lines (L1, L2,..., Lk) and the plurality of data lines (D1, D2, ..., Dm) are connected through the plurality of second TFTs (TB2, TB4,..., TBm-1), and
when one of the plurality of lines (L1, L2,..., Lk) is shorted, the plurality of pixels (PX_R, PX_G, PX_B), which are connected to the shorted line via the corresponding ones of the data lines (D1, D2, ..., Dm), is adapted to emit light according to a short voltage resulting from the shorted line.

6. The display panel as claimed in one of the preceding claims, wherein the demultiplexer (200) includes:
a plurality of first TFTs (TA1, TA3,..., TAm) connecting the plurality of lines (L1, L2,..., Lk) and corresponding ones of the data lines among the plurality of data lines (D1, D2, ..., Dm),
a plurality of second TFTs (TB2, TB4,..., TBm-1) connecting the plurality of lines (L1, L2,..., Lk) and corresponding ones of the data lines among the plurality of data lines (D1, D2, ..., Dm), and
the defect detecting device (100) is configured to reveal a defect in the plurality of first TFTs (TA1, TA3,..., TAm) and the plurality of second TFTs (TB2, TB4,..., TBm-1) in a state when the plurality of first TFTs (TA1, TA3,..., TAm) and the plurality of second TFTs (TB2, TB4,..., TBm-1) are in an on state, and only one of the plurality of first switches (T11, T12, ..., T1a) or the plurality of second switches (T21, T22,..., T2b) are in an on state.

7. The display panel as claimed in claim 6, wherein when the plurality of first switches (T11, T12, ..., T1a) are in an on state, the plurality of second switches (T21, T22,..., T2b) are in an off state, and the plurality of first TFTs (TA1, TA3,..., TAm) and the plurality of second TFTs (TB2, TB4,..., TBm-1) are in an on state, the first data lines (D1, D2, D3, D7, D8, D9), which are respectively connected to the plurality of first switches (T11, T12, ..., T1a) in the on state are connected to corresponding ones of the second data lines (D4, D5, D6, Dm-5, Dm-4, Dm-3) through a respective ones of the first TFTs (TA1, TA3,..., Tam) and a respective one of the second TFTs (TB2, TB4,..., TBm-1).

8. The display panel as claimed in claim 6, wherein when the plurality of second switches (T21, T22,..., T2b) are in an on state, the plurality of first switches (T11, T12, ..., T1a) are in an off state, and the plurality of first TFTs (TA1, TA3,..., TAm) and the plurality of second TFTs (TB2, TB4,..., TBm-1) are in an on state, the second data lines (D4, D5, D6, Dm-5, Dm-4, Dm-3), which are respectively connected to the plurality of the second switches (T21, T22,..., T2b) in the on state are connected to corresponding ones of the first data lines (D1, D2, D3, D7, D8, D9) through a respective one of the first TFTs (TA1, TA3,..., Tam) and a respective one of the second TFTs (TB2, TB4,..., TBm-1).

9. A defect detecting method for a line (L1, L2,..., Lk) of a display panel according to one of claims 1 to 8, the line (L1, L2,..., Lk) being connected to a first data line (D1, D3, D5, D7, D9) corresponding to a first pixel array through a first TFT (TA1, TA3,..., TAm) and connected to a second data line (D2, D4, D6, D8) corresponding to a second pixel array through a second TFT (TB2, TB4,..., TBm-1), the defect detecting method comprising:
simultaneously supplying the first DC voltage to the first data line (D1, D3, D5, D7, D9) and the second data line (D2, D4, D6, D8) wherein the first DC voltage is a non-emitting voltage where the pixels (PX_R, PX_G, PX_B) do not emit light;
turning on only one of the first TFT (TA1, TA3,..., TAm) and the second TFT (TB2, TB4,..., TBm-1); and
detecting a defect causing the voltage on the respective one of the data lines to be at a level at which the respective pixel emits light according to a light emitting state of the first or the second pixel array connected to the line (L1, L2,..., Lk) through the turned-on one among the first TFTs (TA1, TA3,..., TAm) and the second TFTs (TB2, TB4,..., TBm-1)..

10. The defect detecting method as claimed in claim 9, wherein when the first TFT (TA1, TA3,..., TAm) is turned on, detecting a defect includes detecting the line (L1, L2,..., Lk) as defective when the first pixel array is in a light emitting state that produces a dark line or a bright line relative to a predetermined luminance, and/or
wherein when the second TFT (TB2, TB4,..., TBm-1) is turned on, detecting a defect includes detecting the line (L1, L2,..., Lk) as defective when the second pixel array is in a light emitting state that produces a dark line or a bright line relative to a predetermined luminance.

11. The defect detecting method as claimed in claim 10, wherein the predetermined luminance corresponds to an intermediate grayscale level among a grayscale range.

12. A defect detecting method for a demultiplexer (200) of a display panel according to one of claims 1 to 8, the defect detecting method comprising:
turning on only one of the plurality of first switches (T11, T12, ..., T1a) and the plurality of second switches (T21, T22,..., T2b);
turning on the first TFTs (TA1, TA3,..., TAm) and the second TFTs (TB2, TB4,..., TBm-1); and
detecting a defect in one of the first TFTs (TA1, TA3,..., TAm) and/or one of the second TFTs (TB2, TB4,..., TBm-1) according to a light emitting state of the first pixel array and the second pixel array.

13. The defect detecting method as claimed in claim 12, wherein detecting a defect includes detecting a defect in one of the first TFTs (TA1, TA3,..., TAm) and/or one of the second TFTs (TB2, TB4,..., TBm-1) when the light emitting state of the corresponding first pixel array and the corresponding second pixel array are different.

14. The defect detecting method as claimed in claim 13, wherein when the plurality of first switches (T11, T12, ..., T1a) is turned on, detecting a defect includes detecting at least one of the first TFTs (TA1, TA3,..., TAm) and the second TFTs (TB2, TB4,..., TBm-1) as defective when the first pixel array is displayed with black and the second pixel array is displayed with a predetermined luminance.

15. The defect detecting method as claimed in one of claims 13 and 14, wherein when the plurality of second switches (T21, T22,..., T2b) is turned on, detecting a defect includes detecting at least one of the first TFTs (TA1, TA3,..., TAm) and the second TFTs (TB2, TB4,..., TBm-1) as defective when the second pixel array is displayed with black, and the first pixel array is displayed with a predetermined luminance.

## Patentansprüche

1. Anzeigetafel, umfassend:
eine Mehrzahl von Datenleitungen (D1, D2, ..., Dm);
eine Mehrzahl von Pixeln (PX_R, PX_G, PX_B), die jeweils mit der Mehrzahl von Datenleitungen (D1, D2, ..., Dm) verbunden sind;
einen Demultiplexer (200), der eine Mehrzahl von Datenleitungen (D1, D2, ..., Dm) mit einer Mehrzahl von entsprechenden Leitungen (L1, L2,..., Lk) verbindet; und
eine Fehlererkennungsvorrichtung (100), die zum Erkennen eines Fehlers in einer Mehrzahl von Leitungen (L1, L2,..., Lk) und/oder dem Demultiplexer (200) konfiguriert ist,
wobei die Fehlererkennungsvorrichtung (100) Folgendes umfasst:
erste bis dritte Gleichstromleitungen (DC_R, DC_G, DC_B), die mit ersten bis dritten Spannungen versorgt werden;
eine Mehrzahl von ersten Schaltern (T11, T12, ..., T1a), die mit den ersten bis dritten Gleichstromleitungen (DC_R, DC_G, DC_B) verbunden und dafür konfiguriert sind, gemäß einem ersten Gate-Signal eine der ersten bis dritten Gleichspannungen an eine Mehrzahl von ersten Datenleitungen (D1, D2, D3, D7, D8, D9) aus der Mehrzahl von Datenleitungen (D1, D2, ..., Dm) zu übertragen; und
eine Mehrzahl von zweiten Schaltern (T21, T22, ..., T2b), die mit den ersten bis dritten Gleichstromleitungen (DC_R, DC_G, DC_B) verbunden und dafür konfiguriert sind, gemäß einem zweiten Gate-Signal eine der ersten bis dritten Gleichspannungen an eine Mehrzahl von zweiten Datenleitungen (D4, D5, D6, Dm-5, Dm-4, Dm-3) aus der Mehrzahl von Datenleitungen (D1, D2, ..., Dm) zu übertragen, wobei der Demultiplexer (200) Folgendes beinhaltet:
eine Mehrzahl von ersten DFTs (TA1, TA3,..., Tam), die zwischen der Mehrzahl von Leitungen (L1, L2,..., Lk) und entsprechenden solchen aus einer Mehrzahl von Datenleitungen (D1, D3, ...Dm) verbunden sind, und
eine Mehrzahl von zweiten DFTs (TB2, TB4,..., TBm-1), die zwischen der Mehrzahl von Leitungen (L1, L2,..., Lk) und entsprechenden solchen einer anderen Mehrzahl von Datenleitungen (D2, D4, ...Dm-1) verbunden sind, und
**dadurch gekennzeichnet, dass**
die Fehlererkennungsvorrichtung (100) dafür konfiguriert ist, die ersten bis dritten Gleichstromleitungen (DC_R, DC_G, DC_B) auf eine grau-emittierende Spannung zu bringen, bei der die Pixel (PX_R, PX_G, PX_B) eine mittlere Graustufe emittieren, und einen Kurzschlussfehler unter der Mehrzahl von Leitungen (L1, L2,..., Lk) aufzudecken, indem die Pixelmatrix, die mit der Kurzschlussleitung verbunden ist, in einem Zustand, in dem sich die Mehrzahl der ersten Schalter (T11, T12, ..., T1a) und die Mehrzahl der zweiten Schalter (T21, T22,..., T2b) der Fehlererkennungsvorrichtung (100) gleichzeitig in einem eingeschalteten Zustand befindet, und sich nur einer der Mehrzahl von ersten DFTs (TA1, TA3,..., TAm) und der Mehrzahl von zweiten DFTs (TB2, TB4,..., TBm-1) des Demultiplexers (200) in einem eingeschalteten Zustand befindet, zum Emittieren von Licht mit einer hohen Luminanz, das sich von der mittleren Graustufe unterscheidet, oder zu gar keinem Emittieren von Licht veranlasst wird, und
die Fehlererkennungsvorrichtung (100) ferner dafür konfiguriert ist, die ersten bis dritten Gleichstromleitungen (DC_R, DC_G, DC_B) auf eine nichtemittierende Spannung zu bringen, bei der die Pixel (PX_R, PX_G, PX_B) kein Licht emittieren, und einen Fehler in der Mehrzahl von ersten DFTs (TA1, TA3,..., TAm) und der Mehrzahl von zweiten DFTs (TB2, TB4,..., TBm-1) aufzudecken, indem die Spannung auf der entsprechenden einen der Datenleitungen in einem Zustand, in dem sich die Mehrzahl von ersten DFTs (TA1, TA3,..., TAm) und der Mehrzahl von zweiten DFTs (TB2, TB4,..., TBm-1) gleichzeitig in einem eingeschalteten Zustand befindet, und sich nur einer der Mehrzahl von ersten Schaltern (T11, T12, ..., T1a) und der Mehrzahl von zweiten Schaltern (T21, T22,..., T2b) in einem eingeschalteten Zustand befindet, auf ein Niveau gebracht wird, bei dem die Pixel Licht emittieren.

2. Anzeigetafel nach Anspruch 1, wobei jeder der Mehrzahl von ersten Schaltern (T11, T12, ..., T1a) eine Gate-Elektrode, die zum Empfangen eines ersten Gate-Signals konfiguriert ist, eine erste Elektrode, die mit einer entsprechenden einen der ersten bis dritten Gleichstromleitungen (DC_R, DC_G, DC_B) verbunden ist, und eine zweite Elektrode, die mit einer entsprechenden einen der ersten Datenleitungen (D1, D2, D3, D7, D8, D9) verbunden ist, beinhaltet.

3. Anzeigetafel nach einem der vorhergehenden Ansprüche, wobei jeder der Mehrzahl von zweiten Schaltern (T21, T22,..., T2b) eine Gate-Elektrode, die zum Empfangen eines zweiten Gate-Signals konfiguriert ist, eine erste Elektrode, die mit einer entsprechenden einen der ersten bis dritten Gleichstromleitungen (DC_R, DC_G, DC_B) verbunden ist, und eine zweite Elektrode, die mit einer entsprechenden einen der zweiten Datenleitungen (D4, D5, D6, Dm-5, Dm-4, Dm-3) verbunden ist, beinhaltet.

4. Anzeigetafel nach einem der vorhergehenden Ansprüche, wobei:
wenn sich die Mehrzahl von ersten DFTs (TA1, TA3,..., TAm) in dem eingeschalteten Zustand befindet, entsprechende solche der Mehrzahl von Leitungen (L1, L2,..., Lk) und der Mehrzahl von Datenleitungen (D1, D2, ..., Dm) jeweils durch die Mehrzahl von ersten DFTs (TA1, TA3,..., TAm) verbunden sind, und
wenn eine der Mehrzahl von Leitungen (L1, L2,..., Lk) einen Kurzschluss aufweist, die Mehrzahl von Pixeln (PX_R, PX_G, PX_B), die über entsprechende solche der Datenleitungen (D1, D2, ..., Dm) mit der Kurzschlussleitung verbunden sind, zum Emittieren von Licht entsprechend einer Kurzschlussspannung, die von der Kurzschlussleitung ausgeht, ausgelegt ist.

5. Anzeigetafel nach einem der vorhergehenden Ansprüche, wobei:
wenn sich die Mehrzahl von zweiten DFTs (TB2, TB4,..., TBm-1) in dem eingeschalteten Zustand befindet, entsprechende solche der Mehrzahl von Leitungen (L1, L2,..., Lk) und der Mehrzahl von Datenleitungen (D1, D2, ..., Dm) durch die Mehrzahl von zweiten DFTs (TB2, TB4,..., TBm-1) verbunden sind, und
wenn eine der Mehrzahl von Leitungen (L1, L2,..., Lk) einen Kurzschluss aufweist, die Mehrzahl von Pixeln (PX_R, PX_G, PX_B), die über entsprechende solche der Datenleitungen (D1, D2, ..., Dm) mit der Kurzschlussleitung verbunden sind, zum Emittieren von Licht entsprechend einer Kurzschlussspannung, die von der Kurzschlussleitung ausgeht, ausgelegt ist.

6. Anzeigetafel nach einem der vorhergehenden Ansprüche, wobei der Demultiplexer (200) Folgendes beinhaltet:
eine Mehrzahl von ersten DFTs (TA1, TA3,..., Tam), die die Mehrzahl von Leitungen (L1, L2,..., Lk) und entsprechende solche einen Datenleitungen aus der Mehrzahl von Datenleitungen (D1, D2, ...Dm) verbinden,
eine Mehrzahl von zweiten DFTs (TB2, TB4,..., TBm-1), die die Mehrzahl von Leitungen (L1, L2,..., Lk) und entsprechende solche einen Datenleitungen aus der Mehrzahl von Datenleitungen (D1, D2, ..., Dm) verbinden, und
die Fehlererkennungsvorrichtung (100) dafür konfiguriert ist, einen Fehler in der Mehrzahl von ersten DFTs (TA1, TA3,..., TAm) und der Mehrzahl von zweiten DFTs (TB2, TB4,..., TBm-1) in einem Zustand aufzudecken, in dem sich die Mehrzahl von ersten DFTs (TA1, TA3,..., TAm) und die Mehrzahl von zweiten DFTs (TB2, TB4,..., TBm-1) in einem eingeschalteten Zustand befindet, und sich nur einer von der Mehrzahl von ersten Schaltern (T11, T12, ..., T1a) oder der Mehrzahl von zweiten Schaltern (T21, T22,..., T2b) in einem eingeschalteten Zustand befindet.

7. Anzeigetafel nach Anspruch 6, wobei, wenn sich die Mehrzahl von ersten Schaltern (T11, T12, ..., T1a) in einem eingeschalteten Zustand befindet, sich die Mehrzahl von zweiten Schaltern (T21, T22,..., T2b) in einem ausgeschalteten Zustand befindet, und sich die Mehrzahl von ersten DFTs (TA1, TA3,..., TAm) und die Mehrzahl von zweiten DFTs (TB2, TB4,..., TBm-1) in einem eingeschalteten Zustand befindet, die ersten Datenleitungen (D1, D2, D3, D7, D8, D9), die jeweils mit der Mehrzahl von ersten Schaltern (T11, T12, ..., T1a) im eingeschalteten Zustand verbunden sind, mit entsprechenden solchen der zweiten Datenleitungen (D4, D5, D6, Dm-5, Dm-4, Dm-3) durch einen entsprechenden solchen der ersten DFTs (TA1, TA3,..., Tam) und einen entsprechenden solchen der zweiten DFTs (TB2, TB4,..., TBm-1) verbunden sind.

8. Anzeigetafel nach Anspruch 6, wobei, wenn sich die Mehrzahl von zweiten Schaltern (T21, T22,..., T2b) in einem eingeschalteten Zustand befindet, sich die Mehrzahl von ersten Schaltern (T11, T12, ..., T1a) in einem ausgeschalteten Zustand befindet, und sich die Mehrzahl von zweiten DFTs (TB2, TB4,..., TBm-1) in einem eingeschalteten Zustand befindet, die zweiten Datenleitungen (D4, D5, D6, Dm-5, Dm-4, Dm-3), die jeweils mit der Mehrzahl der zweiten Schalter (T21, T22,..., T2b) im eingeschalteten Zustand verbunden sind, mit entsprechenden solchen der ersten Datenleitungen (D1, D2, D3, D7, D8, D9) durch einen entsprechenden solchen der ersten DFTs (TA1, TA3,..., Tam) und einen entsprechenden solchen der zweiten DFTs (TB2, TB4,..., TBm-1) verbunden sind.

9. Fehlererkennungsverfahren für eine Leitung (L1, L2,..., Lk) einer Anzeigetafel nach einem der Ansprüche 1 bis 8, wobei die Leitung (L1, L2,..., Lk) entsprechend einer ersten Pixelmatrix durch einen ersten DFT (TA1, TA3,..., TAm) mit einer ersten Datenleitung (D1, D3, D5, D7, D9) verbunden ist und entsprechend einer zweiten Pixelmatrix durch einen zweiten DFT (TB2, TB4,..., TBm-1) mit einer zweiten Datenleitung (D2, D4, D6, D8) verbunden ist, wobei das Fehlererkennungsverfahren Folgendes umfasst:
gleichzeitiges Versorgen der ersten Datenleitung (D1, D3, D5, D7, D9) und der zweiten Datenleitung (D2, D4, D6, D8) mit der ersten Gleichspannung, wobei die erste Gleichspannung eine nichtemittierende Spannung ist, bei der die Pixel (PX_R, PX_G, PX_B) kein Licht emittieren;
Einschalten von nur einem der ersten DFTs (TA1, TA3,..., TAm) und der zweiten DFTs (TB2, TB4,..., TBm-1); und
Erkennen eines Fehlers, der bewirkt, dass sich die Spannung auf der jeweiligen einen der Datenleitungen auf einem Niveau befindet, bei dem das jeweilige Pixel entsprechend einem lichtemittierenden Zustand der ersten oder der zweiten Pixelmatrix, die durch den eingeschalteten einen der ersten DFTs (TA1, TA3,..., TAm) und der zweiten DFTs (TB2, TB4,..., TBm-1) mit der Leitung (L1, L2,..., Lk) verbunden sind, Licht emittiert.

10. Fehlererkennungsverfahren nach Anspruch 9, wobei, wenn der erste DFT (TA1, TA3,..., TAm) eingeschaltet ist, das Erkennen eines Fehlers das Erkennen der Leitung (L1, L2,..., Lk) als fehlerhaft beinhaltet, wenn sich die erste Pixelmatrix in einem lichtemittierenden Zustand befindet, der in Bezug auf eine vorbestimmte Luminanz eine dunkle Linie oder eine helle Linie erzeugt, und/oder
wobei, wenn der zweite DFT (TB2, TB4,..., TBm-1) eingeschaltet ist, das Erkennen eines Fehlers das Erkennen der Leitung (L1, L2,..., Lk) als fehlerhaft beinhaltet, wenn sich die zweite Pixelmatrix in einem lichtemittierenden Zustand befindet, der in Bezug auf eine vorbestimmte Luminanz eine dunkle Linie oder eine helle Linie erzeugt.

11. Fehlererkennungsverfahren nach Anspruch 10, wobei die vorbestimmte Luminanz einer mittleren Graustufe in einem Graustufenbereich entspricht.

12. Fehlererkennungsverfahren für einen Demultiplexer (200) einer Anzeigetafel nach einem der Ansprüche 1 bis 8, wobei das Fehlererkennungsverfahren Folgendes umfasst:
Einschalten von nur einem der Mehrzahl von ersten Schaltern (T11, T12, ..., T1a) und der Mehrzahl von zweiten Schaltern (T21, T22,..., T2b);
Einschalten der ersten DFTs (TA1, TA3,..., TAm) und der zweiten DFTs (TB2, TB4,..., TBm-1); und
Erkennen eines Fehlers in einem der ersten DFTs (TA1, TA3,..., TAm) und/oder einem der zweiten DFTs (TB2, TB4,..., TBm-1) entsprechend einem lichtemittierenden Zustand der ersten Pixelmatrix und der zweiten Pixelmatrix.

13. Fehlererkennungsverfahren nach Anspruch 12, wobei das Erkennen eines Fehlers das Erkennen eines Fehlers in einem der ersten DFTs (TA1, TA3,..., TAm) und/oder einem der zweiten DFTs (TB2, TB4,..., TBm-1) beinhaltet, wenn der lichtemittierende Zustand der ersten Pixelmatrix und der entsprechenden zweiten Pixelmatrix unterschiedlich sind.

14. Fehlererkennungsverfahren nach Anspruch 13, wobei, wenn die Mehrzahl von ersten Schaltern (T11, T12, ..., T1a) eingeschaltet ist, das Erkennen eines Fehlers das Erkennen mindestens eines der ersten DFTs (TA1, TA3,..., TAm) und der zweiten DFTs (TB2, TB4,..., TBm-1) als fehlerhaft beinhaltet, wenn die erste Pixelmatrix mit schwarz und die zweite Pixelmatrix mit einer vorbestimmten Luminanz angezeigt wird.

15. Fehlererkennungsverfahren nach einem der Ansprüche 13 und 14, wobei, wenn die Mehrzahl von zweiten Schaltern (T21, T22,..., T2b) eingeschaltet ist, das Erkennen eines Fehlers das Erkennen mindestens eines der ersten DFTs (TA1, TA3,..., TAm) und der zweiten DFTs (TB2, TB4,..., TBm-1) als fehlerhaft beinhaltet, wenn die zweite Pixelmatrix mit schwarz und die erste Pixelmatrix mit einer vorbestimmten Luminanz angezeigt wird.

## Revendications

1. Panneau d'affichage comprenant :
une pluralité de lignes de données (D1, D2, ..., Dm) ;
une pluralité de pixels (PX_R, PX_G, PX_B) respectivement reliés à la pluralité de lignes de données (D1, D2, ..., Dm) ;
un démultiplexeur (200) reliant une pluralité de lignes de données (D1, D2, ..., Dm) à une pluralité de lignes correspondantes (L1, L2, ..., Lk) ; et
un dispositif de détection de défaut (100) configuré pour détecter un défaut dans une pluralité de lignes (L1, L2, ..., Lk) et/ou dans le démultiplexeur (200),
dans lequel le dispositif de détection de défaut (100) comprend :
des première à troisième lignes de courant continu (DC) (DC_R, DC_G, DC_B) alimentées par des première à troisième tensions de courant continu (DC) ;
une pluralité de premiers commutateurs (T11, T12, ..., T1a) reliés aux première à troisième lignes DC (DC_R, DC_G, DC_B) et configurés pour transmettre l'une des première à troisième tensions DC à une pluralité des premières lignes de données (D1, D2, D3, D7, D8, D9) parmi la pluralité de lignes de données (D1, D2, ..., Dm) en fonction d'un premier signal de grille ; et
une pluralité de deuxièmes commutateurs (T21, T22, ..., T2b) reliés aux première à troisième lignes DC (DC_R, DC_G, DC_B) et configurés pour transmettre l'une des première à troisième tensions DC à une pluralité de deuxièmes lignes de données (D4, D5, D6, Dm-5, Dm-4, Dm-3) parmi la pluralité de lignes de données (D1, D2, ..., Dm) en fonction d'un deuxième signal de grille, où le démultiplexeur (200) comporte :
une pluralité de premiers TFT (TA1, TA3, ..., TAm) reliés entre la pluralité de lignes (L1, L2, ..., Lk) et des lignes correspondantes d'une pluralité de lignes de données (D1, D3, ..., Dm), et
une pluralité de deuxièmes TFT (TB2, TB4, ..., TBm-1) reliés entre la pluralité de lignes (L1, L2, ..., Lk) et des lignes correspondantes d'une autre pluralité de lignes de données (D2, D4, ..., Dm-1), et
**caractérisé en ce que**
le dispositif de détection de défaut (100) est configuré pour exciter les première à troisième lignes DC (DC_R, DC_G, DC_B) à une tension émettant des niveaux de gris où les pixels (PX_R, PX_G, PX_B) émettent une échelle de gris intermédiaire et pour révéler un défaut de court circuit parmi la pluralité de lignes (L1, L2, ..., Lk) en amenant le réseau de pixels relié à la ligne court-circuitée à émettre de la lumière avec une luminance élevée différente de l'échelle de gris intermédiaire ou à ne pas émettre de lumière du tout,
dans un état où la pluralité des premiers commutateurs (T11, T12, ..., T1a) et la pluralité des deuxièmes commutateurs (T21, T22, ..., T2b) du dispositif de détection de défaut (100) se trouvent dans un état passant, simultanément, et seulement l'une de la pluralité des premiers TFT (TA1, TA3, ..., TAm) et de la pluralité des deuxièmes TFT (TB2, TB4, ..., TBm-1) du démultiplexeur (200) se trouve dans un état passant, et
le dispositif de détection de défaut (100) est en outre configuré pour exciter les première à troisième lignes DC (DC_R, DC_G, DC_B) à une tension non émettrice où les pixels (PX_R, PX_G, PX_B) n'émettent pas de lumière et pour révéler un défaut dans la pluralité de premiers TFT (TA1, TA3, ..., TAm) et la pluralité de deuxièmes TFT (TB2, TB4, ..., TBm-1) en amenant la tension sur la ligne correspondante des lignes de données à être à un niveau auquel les pixels respectifs émettent de la lumière, dans un état où la pluralité de premiers TFT (TA1, TA3, ..., TAm) et la pluralité de deuxièmes TFT (TB2, TB4, ..., TBm-1) se trouvent dans un état passant, simultanément, et seulement l'une de la pluralité de premiers commutateurs (T11, T12, ..., T1a) et de la pluralité de deuxièmes commutateurs (T21, T22, ..., T2b) se trouve dans un état passant.

2. Panneau d'affichage tel que revendiqué dans la revendication 1, dans lequel chacun de la pluralité de premiers commutateurs (T11, T12, ..., T1a) comporte une électrode de grille configurée pour recevoir le premier signal de grille, une première électrode reliée à une ligne correspondante des première à troisième lignes DC (DC_R, DC_G, DC_B), et une deuxième électrode reliée à une ligne correspondante des premières lignes de données (D1, D2, D3, D7, D8, D9).

3. Panneau d'affichage tel que revendiqué dans l'une des revendications précédentes, dans lequel chacun de la pluralité de deuxièmes commutateurs (T21, T22, ..., T2b) comporte une électrode de grille configurée pour recevoir le deuxième signal de grille, une première électrode reliée à une ligne correspondante des première à troisième lignes DC (DC_R, DC_G, DC_B), et une deuxième électrode reliée à une ligne correspondante des deuxièmes lignes de données (D4, D5, D6, Dm-5, Dm-4, Dm-3).

4. Panneau d'affichage tel que revendiqué dans l'une des revendications précédentes, dans lequel :
lorsque la pluralité des premiers TFT (TA1, TA3, ..., TAm) se trouvent dans l'état passant, des lignes correspondantes de la pluralité de lignes (L1, L2, ..., Lk) et de la pluralité de lignes de données (D1, D2, ..., Dm) sont reliées par l'intermédiaire de la pluralité de premiers TFT (TA1, TA3, ..., TAm), respectivement, et
lorsque l'une de la pluralité de lignes (L1, L2, ..., Lk) est court-circuitée, la pluralité de pixels (PX_R, PX_G, PX_B), qui sont reliés à la ligne court-circuitée par l'intermédiaire de lignes correspondantes des lignes de données (D1, D2, ..., Dm), sont adaptés pour émettre de la lumière en fonction d'une tension de court-circuit résultant de la ligne court-circuitée.

5. Panneau d'affichage tel que revendiqué dans l'une des revendications précédentes, dans lequel :
lorsque la pluralité de deuxièmes TFT (TB2, TB4, ..., TBm-1) se trouvent dans l'état passant, des lignes correspondantes de la pluralité de lignes (L1, L2, ..., Lk) et de la pluralité de lignes de données (D1, D2, ..., Dm) sont reliées par l'intermédiaire de la pluralité de deuxièmes TFT (TB2, TB4, ..., TBm-1), et
lorsque l'une de la pluralité de lignes (L1, L2, ..., Lk) est court-circuitée, la pluralité de pixels (PX_R, PX_G, PX_B), qui sont reliés à la ligne court-circuitée par l'intermédiaire de lignes correspondantes des lignes de données (D1, D2, ..., Dm), sont adaptés pour émettre de la lumière en fonction d'une tension de court-circuit résultant de la ligne court-circuitée.

6. Panneau d'affichage tel que revendiqué dans l'une des revendications précédentes, dans lequel le démultiplexeur (200) comporte :
une pluralité de premiers TFT (TA1, TA3, ..., TAm) reliant la pluralité de lignes (L1, L2, ..., Lk) et des lignes correspondantes des lignes de données parmi la pluralité de lignes de données (D1, D2, ..., Dm),
une pluralité de deuxièmes TFT (TB2, TB4, ..., TBm-1) reliant la pluralité de lignes (L1, L2, ..., Lk) et des lignes correspondantes des lignes de données parmi la pluralité de lignes de données (D1, D2, ..., Dm), et
le dispositif de détection de défaut (100) est configuré pour révéler un défaut dans la pluralité de premiers TFT (TA1, TA3, ..., TAm) et la pluralité de deuxièmes TFT (TB2, TB4, ..., TBm-1) dans un état où la pluralité de premiers TFT (TA1, TA3, ..., TAm) et la pluralité de deuxièmes TFT (TB2, TB4, ..., TBm-1) se trouvent dans un état passant, et seulement l'une de la pluralité de premiers commutateurs (T11, T12, ..., T1a) et de la pluralité de deuxièmes commutateurs (T21, T22, ..., T2b) se trouve dans un état passant.

7. Panneau d'affichage tel que revendiqué dans la revendication 6, dans lequel lorsque la pluralité de premiers commutateurs (T11, T12, ..., T1a) se trouvent dans un état passant, la pluralité de deuxièmes commutateurs (T21, T22, ..., T2b) se trouvent dans un état bloqué, et la pluralité de premiers TFT (TA1, TA3, ..., TAm) et la pluralité de deuxièmes TFT (TB2, TB4, ..., TBm-1) se trouvent dans un état passant, les premières lignes de données (D1, D2, D3, D7, D8, D9), qui sont respectivement reliées à la pluralité de premiers commutateurs (T11, T12, ..., T1a) dans l'état passant sont reliées aux lignes correspondantes des deuxièmes lignes de données (D4, D5, D6, Dm-5, Dm-4, Dm-3) par l'intermédiaire de TFT respectifs des premiers TFT (TA1, TA3, ..., TAm) et d'un TFT respectif des deuxièmes TFT (TB2, TB4, ..., TBm-1).

8. Panneau d'affichage tel que revendiqué dans la revendication 6, dans lequel, lorsque la pluralité de deuxièmes commutateurs (T21, T22, ..., T2b) se trouvent dans l'état passant, la pluralité de premiers commutateurs (T11, T12, ..., T1a) se trouvent dans un état bloqué et la pluralité de premiers TFT (TA1, TA3, ..., TAm) et la pluralité de deuxièmes TFT (TB2, TB4, ..., TBm-1) se trouvent dans un état passant, les deuxièmes lignes de données (D4, D5, D6, Dm-5, Dm-4, Dm-3), qui sont respectivement reliées à la pluralité de deuxièmes commutateurs (T21, T22, ..., T2b) dans l'état passant sont reliées à des lignes correspondantes des premières lignes de données (D1, D2, D3, D7, D8, D9) par l'intermédiaire d'un TFT respectif des premiers TFT (TA1, TA3, ..., TAm) et d'un TFT respectif des deuxièmes TFT (TB2, TB4, ..., TBm-1).

9. Procédé de détection de défaut pour une ligne (L1, L2, ..., Lk) d'un panneau d'affichage selon l'une des revendications 1 à 8, la ligne (L1, L2, ..., Lk) étant reliée à une première ligne de données (D1, D3, D5, D7, D9) correspondant à un premier réseau de pixels par l'intermédiaire d'un premier TFT (TA1, TA3, ..., TAm) et reliée à une deuxième ligne de données (D2, D4, D6, D8) correspondant à un deuxième réseau de pixels par l'intermédiaire d'un deuxième TFT (TB2, TB4, ..., TBm-1), le procédé de détection de défaut comprenant le fait :
de fournir simultanément la première tension DC à la première ligne de données (D1, D3, D5, D7, D9) et à la deuxième ligne de données (D2, D4, D6, D8) ; où la première tension DC est une tension non émettrice où les pixels (PX_R, PX_G, PX_B) n'émettent pas de lumière ;
d'activer un seul TFT des premiers TFT (TA1, TA3, ..., TAm) et des deuxièmes TFT (TB2, TB4, ..., TBm-1) ; et
de détecter un défaut amenant la tension sur la ligne respective des lignes de données à être à un niveau auquel le pixel respectif émet de la lumière en fonction d'un état d'émission de lumière du premier ou du deuxième réseau de pixels relié à la ligne (L1, L2, ..., Lk) par l'intermédiaire du TFT activé parmi les premiers TFT (TA1, TA3, ..., TAm) et les deuxièmes TFT (TB2, TB4, ..., TBm-1).

10. Procédé de détection de défaut tel que revendiqué dans la revendication 9, dans lequel, lorsque le premier TFT (TA1, TA3, ..., TAm) est activé, la détection d'un défaut comporte le fait de détecter la ligne (L1, L2, ..., Lk) comme étant défectueuse lorsque le premier réseau de pixels se trouve dans un état d'émission de lumière qui produit une ligne sombre ou une ligne claire par rapport à une luminance prédéterminée, et/ou
dans lequel, lorsque le deuxième TFT (TB2, TB4, ..., TBm-1) est activé, la détection d'un défaut comporte le fait de détecter la ligne (L1, L2, ..., Lk) comme étant défectueuse lorsque le deuxième réseau de pixels se trouve dans un état d'émission de lumière qui produit une ligne sombre ou une ligne claire par rapport à une luminance prédéterminée.

11. Procédé de détection de défaut tel que revendiqué dans la revendication 10, dans lequel la luminance prédéterminée correspond à un niveau d'échelle de gris intermédiaire parmi une plage d'échelle de gris.

12. Procédé de détection de défaut pour un démultiplexeur (200) d'un panneau d'affichage selon l'une des revendications 1 à 8, le procédé de détection de défaut comprenant le fait :
d'activer seulement un commutateur de la pluralité de premiers commutateurs (T11, T12, ..., T1a) et de la pluralité de deuxièmes commutateurs (T21, T22, ..., T2b) ;
d'activer les premiers TFT (TA1, TA3, ..., TAm) et les deuxièmes TFT (TB2, TB4, ..., TBm-1) ; et
de détecter un défaut dans l'un des premiers TFT (TA1, TA3, ..., TAm) et/ou dans l'un des deuxièmes TFT (TB2, TB4, ..., TBm-1) en fonction d'un état d'émission de lumière du premier réseau de pixels et du deuxième réseau de pixels.

13. Procédé de détection de défaut tel que revendiqué dans la revendication 12, dans lequel la détection d'un défaut comporte le fait de détecter un défaut dans l'un des premiers TFT (TA1, TA3, ..., TAm) et/ou l'un des deuxièmes TFT (TB2, TB4, ..., TBm-1) lorsque les états d'émission de lumière du premier réseau de pixels correspondant et du deuxième réseau de pixels correspondant sont différents.

14. Procédé de détection de défaut tel que revendiqué dans la revendication 13, dans lequel lorsque la pluralité de premiers commutateurs (T11, T12, ..., T1a) sont activés, la détection d'un défaut comporte le fait de détecter au moins l'un des premiers TFT (TA1, TA3, ..., TAm) et des deuxièmes TFT (TB2, TB4, ..., TBm-1) comme étant défectueux lorsque le premier réseau de pixels est affiché en noir et le deuxième réseau de pixels est affiché avec une luminance prédéterminée.

15. Procédé de détection de défaut tel que revendiqué dans l'une des revendications 13 et 14, dans lequel lorsque la pluralité de deuxièmes commutateurs (T21, T22, ..., T2b) sont activés, la détection d'un défaut comporte le fait de détecter au moins l'un des premiers TFT (TA1, TA3, ..., TAm) et des deuxièmes TFT (TB2, TB4, ..., TBm-1) comme étant défectueux lorsque le deuxième réseau de pixels est affiché en noir, et le premier réseau de pixels est affiché avec une luminance prédéterminée.
